# FASCICULE DE BREVET EUROPEEN

(11) **EP 2 340 571 B1**
(45) Date de publication et mention de la délivrance du brevet: **01.08.2012**
(21) Numéro de dépôt: 09741338.9
(22) Date de dépôt: 23.09.2009
(51) Int. Cl.: H01L 37/04

(54) **GENERATEUR THERMIOUE A MATERIAU MAGNETOCALORIOUE**
WÄRMEGENERATOR MIT MAGNETOKALORISCHEM MATERIAL
THERMAL GENERATOR WITH MAGNETOCALORIC MATERIAL

(30) Priorité: 25.09.2008 FR 0805278
(43) Date de publication de la demande: 06.07.2011
(73) Titulaire: Cooltech Applications S.A.S., 67810 Holtzheim (FR)
(72) Inventeur: HEITZLER Jean-Claude, F-68180 Horbourg-Wihr (FR); MULLER Christian, F-67000 Strasbourg (FR)
(74) Mandataire: Nithardt, Roland
(86) Numéro de dépôt international: PCT/FR2009/001129
(87) Numéro de publication internationale: WO 2010/061064

(56) Documents cités:
- WO-A-03/016794
- WO-A-2009/087310
- FR-A- 2 861 454

## Description

### Domaine technique :

La présente invention concerne un générateur thermique à matériau magnétocalorique comportant au moins une unité de génération de flux thermique pourvue d'au moins un module thermique contenant un élément magnétocalorique, traversé par un fluide caloporteur entraîné selon un déplacement alterné de part et d'autre dudit élément magnétocalorique, ledit générateur thermique comportant également un arrangement magnétique mis en mouvement pour soumettre alternativement ledit élément magnétocalorique à une variation de champ magnétique et créer alternativement, dans ledit élément magnétocalorique, un cycle d'échauffement et un cycle de refroidissement, générant la création puis le maintien d'un gradient de température entre les deux extrémités opposées dudit élément magnétocalorique, le déplacement alterné du fluide caloporteur étant synchronisé avec la variation du champ magnétique, l'élément magnétocalorique étant intégré dans un circuit fermé de circulation de fluide caloporteur reliant les deux extrémités opposées dudit élément magnétocalorique et ledit circuit fermé intégrant un unique moyen de déplacement du fluide caloporteur à travers l'élément magnétocalorique dans les deux sens de déplacement.

### Technique antérieure :

La technologie du froid magnétique à température ambiante est connue depuis plus d'une vingtaine d'années et on sait les avantages qu'elle apporte en termes d'écologie et de développement durable. On connaît également ses limites quant à sa puissance calorifique utile et à son rendement. Dès lors, les recherches menées dans ce domaine tendent toutes à améliorer les performances d'un tel générateur, en jouant sur les différents paramètres, tels que la puissance d'aimantation, les performances de l'élément magnétocalorique, la surface d'échange entre le fluide caloporteur et les éléments magnétocaloriques, les performances des échangeurs de chaleur, etc.

Une des difficultés dans la réalisation de générateurs utilisant un ou plusieurs éléments magnétocaloriques réside dans l'échange d'énergie thermique entre ces éléments magnétocaloriques et le ou les circuits utilisant, consommant ou échangeant l'énergie thermique avec le générateur, et reliés à ce dernier. Une solution permettant de réaliser cet échange consiste à faire circuler un fluide caloporteur, liquide ou non, à travers les éléments magnétocaloriques, en synchronisation avec la variation du champ magnétique à laquelle sont soumis les éléments magnétocaloriques et à réaliser ensuite un échange thermique entre ledit fluide caloporteur et lesdits circuits. La publication WO 03/016794 donne un exemple de réalisation dans lequel les éléments magnétocaloriques sont dans un circuit de fluide fermé comportant une pompe de circulation du fluide caloporteur, extérieure au module thermique et nécessitant des moyens de commande et de raccordement spécifiques.

La publication WO2009/087310 donne un autre exemple. La publication décrit un générateur thermique à matériau magnétocalorique comportant au moins une unité de génération de flux thermique pourvue d'au moins un module thermique contenant un élément magnétocalorique, traversé par un fluide caloporteur entraîné selon un déplacement alterné de part et d'autre dudit élément magnétocalorique, ledit générateur thermique comportant également un arrangement magnétique mis en mouvement pour soumettre alternativement ledit élément magnétocalorique à une variation de champ magnétique et créer alternativement, dans ledit élément magnétocalorique, un cycle d'échauffement et un cycle de refroidissement, générant la création puis le maintien d'un gradient de température entre les deux extrémités opposées dudit élément magnétocalorique, le déplacement alterné du fluide caloporteur étant synchronisé avec la variation du champ magnétique, ledit élément magnétocalorique étant intégré dans un circuit fermé de circulation de fluide caloporteur reliant les deux extrémités opposées dudit élément magnétocalorique dans les deux sens de déplacement, ladite unité de génération de flux thermique comporte un organe de fermeture de champ agencé pour boucler le flux magnétique généré par l'arrangement magnétique, et en ce que ledit organe de fermeture de champ est muni d'un organe de commande dudit moyen de déplacement.

Dans sa demande de brevet français n° 07/07612, la demanderesse présente un générateur thermique à matériau magnétocalorique dans lequel le fluide caloporteur est mis en circulation entre les éléments magnétocaloriques et deux chambres d'échange dites chambre chaude et chambre froide. Cette mise en circulation est réalisée par l'intermédiaire de deux jeux de pistons situés en regard des éléments magnétocaloriques et entraînés par une came de commande reliée à un actionneur.

Ce générateur présente toutefois un inconvénient inhérent à la nécessité de deux cames pour actionner les deux jeux de pistons situés de part et d'autre de chaque élément magnétocalorique. Cela entraîne une augmentation du nombre de pièces constituant le générateur, et plus particulièrement du nombre de pièces en mouvement et donc une augmentation du risque de mauvais fonctionnement, un risque d'usure accru du fait du contact permanent entre la came et les pistons, et une dégradation du rendement du générateur. De plus, le nombre important de pièces augmente également l'encombrement du générateur et limite de ce fait sa capacité d'intégration dans des environnements dans lesquels la place disponible est réduite et limitée.

### Exposé de l'invention:

La présente invention selon la revendication 1 vise à pallier ces inconvénients en proposant un générateur thermique dans lequel le nombre d'organes en déplacement est réduit et dont la configuration permet une diminution importante de l'encombrement dudit générateur.

Dans ce but, l'invention concerne un générateur thermique du genre indiqué en préambule, caractérisé en ce que ladite unité de génération de flux thermique comporte un organe de fermeture de champ agencé pour boucler le flux magnétique généré par l'arrangement magnétique et en ce que ledit organe de fermeture de champ est muni d'un organe de commande dudit moyen de déplacement.

Le circuit fermé peut être réalisé par un ou plusieurs conduits ou canaux reliant les extrémités opposées dudit élément magnétocalorique.

L'intégration d'un unique moyen de déplacement permet de limiter le nombre de pièces du générateur thermique et donc d'en réduire le coût de revient. De même, l'utilisation d'un organe nécessaire au fonctionnement du générateur en tant qu'organe permettant de réaliser la manoeuvre des moyens de déplacement du fluide caloporteur permet encore de réduire le nombre de pièces constituant de générateur et, de plus, d'en réduire l'encombrement.

Ledit moyen de déplacement peut être un piston qui se déplace dans une chemise formée dans le circuit fermé correspondant.

De manière avantageuse, l'organe de fermeture de champ peut être réalisé en un matériau magnétisable et être couplé magnétiquement audit arrangement magnétique mobile.

Dans une première variante de réalisation, l'organe de commande peut être un profil de came de forme sensiblement sinusoïdale dont l'amplitude détermine la course des pistons et dont la phase sinusoïdale correspond globalement à un cycle d'échauffement et un cycle de refroidissement des éléments magnétocaloriques.

A cet effet, ledit piston peut comporter une rainure dans laquelle circule ledit profil de came.

Dans une seconde variante de réalisation, ledit piston peut comporter une zone en matériau magnétisable et être couplé magnétiquement audit organe de fermeture de champ formant l'organe de commande.

Dans un premier mode de réalisation, ladite unité de génération de flux thermique peut être pourvue de plusieurs modules thermiques et présenter une structure circulaire dans laquelle les éléments magnétocaloriques sont disposés en cercle autour d'un axe central, l'arrangement magnétique peut être entraîné en rotation autour dudit axe central et lesdits éléments magnétocaloriques peuvent être disposés entre l'arrangement magnétique et l'organe de fermeture de champ.

Dans cette configuration, l'organe de fermeture de champ peut être couplé magnétiquement audit arrangement magnétique et ledit circuit fermé et la chemise dudit piston peuvent être réalisés dans deux pièces circulaires destinées à être assemblées, lesdites pièces circulaire peuvent être sensiblement symétriques par rapport à leur plan d'assemblage, et comporter chacune au moins un évidement formant une partie de la chemise d'un piston et une rainure aux extrémités débouchantes et formant un canal de liaison entre ledit évidement et l'élément magnétocalorique correspondant.

Selon un second mode de réalisation, ladite unité de génération de flux thermique peut présenter une structure linéaire dans laquelle les éléments magnétocaloriques sont alignés et l'arrangement magnétique peut être entraîné en translation alternative le long desdits éléments magnétocaloriques.

Dans ce mode, l'organe de fermeture de champ peut présenter un profil en forme d'étrier dont les deux branches sont munies sur leurs faces internes d'aimants permanents de polarités opposées et formant l'arrangement magnétique et l'organe de commande peut être sous la forme d'un doigt d'entraînement logé dans une gorge correspondante de chaque piston.

En variante, l'organe de fermeture de champ peut également présenter un profil en forme d'étrier dont les deux branches sont munies sur leurs faces internes d'aimants permanents de polarités opposées et formant l'arrangement magnétique, ledit organe de commande peut toutefois comporter deux aimants permanents de polarités différentes disposés à distance et en regard l'un de l'autre et le piston peut comporter un aimant disposé par rapport aux aimants permanents de l'organe de commande de manière à être repoussé par chacun de ces derniers, et donc suivre leur déplacement. Le déplacement de l'organe de commande entraîne ainsi celui du piston, sans contact entre ces derniers, en dehors de l'arrangement magnétique. A cet effet, le piston peut être disposé sensiblement entre les deux aimants permanents de l'organe de commande et préférentiellement au-dessus de ces derniers.

Pour s'assurer que l'échange thermique entre ledit élément magnétocalorique et le fluide caloporteur est réalisé après un changement de phase dudit élément magnétocalorique, ledit générateur peut également comprendre, dans sa version linéaire, un moyen de décalage apte à anticiper et/ou à retarder le déplacement dudit piston par rapport à celui de l'arrangement magnétique.

### Description sommaire des dessins :

La présente invention et ses avantages apparaîtront mieux dans la description suivante d'un mode de réalisation donné à titre d'exemple non limitatif, en référence aux dessins annexés, dans lesquels:
   - la figure 1 est une vue éclatée d'un générateur thermique de configuration circulaire, selon un premier mode de réalisation de l'invention,
   - la figure 2 est une vue frontale en transparence du module thermique du générateur de la figure 1,
   - la figure 3 est une vue en coupe selon le plan III-III de la figure 2,
   - la figure 4 est une vue du détail B de la figure 3,
   - la figure 5 est une vue éclatée d'une variante de réalisation du générateur thermique circulaire,
   - la figure 6 est une vue en coupe longitudinale du générateur représenté à la figure 5,
   - les figures 7A et 7B sont des vues en perspective d'un générateur thermique de configuration linéaire, selon un second mode de réalisation de l'invention, dans deux positions de l'arrangement magnétique, et
   - la figure 8 est une vue en coupe partielle de la figure 7A.

### Différentes manières de réaliser l'invention :

Dans les exemples de réalisation illustrés, les pièces ou parties identiques portent les mêmes références numériques.

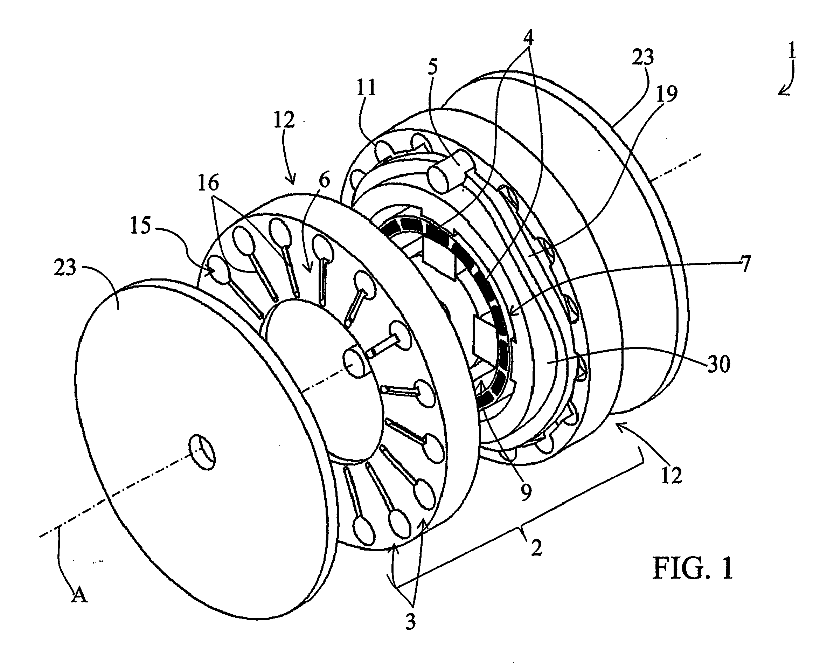

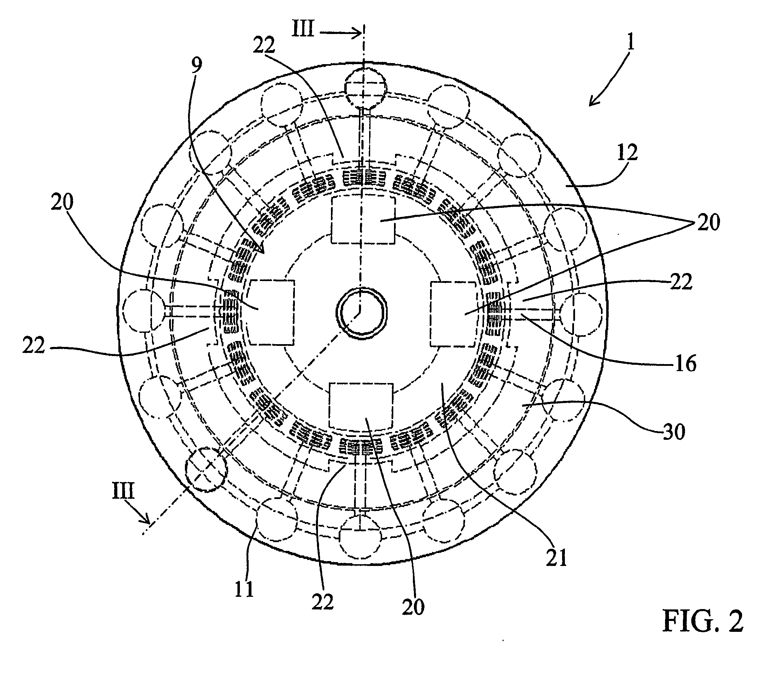

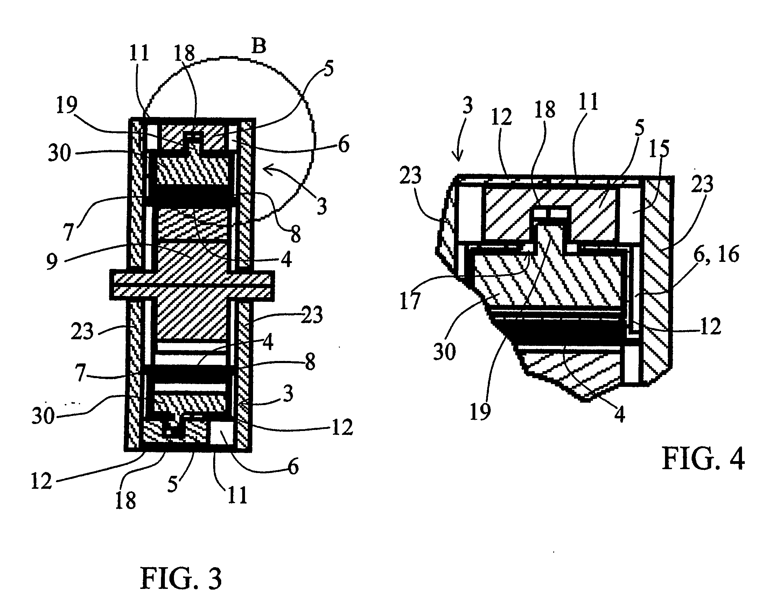

Les figures 1 à 6 représentent un générateur thermique 1 selon un premier mode de réalisation de l'invention dans lequel la structure dudit générateur 1 est circulaire.

Le générateur thermique 1 représenté aux figures 1 à 4 comprend une seule unité 2 de génération de flux thermique. Cette dernière est pourvue de plusieurs modules thermiques 3 comprenant chacun un élément magnétocalorique 4 traversé par un fluide caloporteur par l'intermédiaire d'un moyen de déplacement 5 sous la forme d'un piston. Pour des raisons de simplification, un seul piston 5 est représenté sur la figure 1. Les éléments magnétocaloriques 4 sont disposés en cercle autour d'un axe central A et un arrangement magnétique 9 tourne autour dudit axe central A afin de soumettre les éléments magnétocaloriques 4 à un champ magnétique variable permettant de réaliser alternativement un cycle d'échauffement et un cycle de refroidissement dans ces derniers.

Les éléments magnétocaloriques 4 sont perméables au fluide caloporteur et peuvent être constitués par un ou plusieurs matériaux magnétocaloriques. Ils comportent des passages de fluide débouchant qui peuvent être constitués par les pores d'un matériau poreux, des mini ou micro-canaux usinés dans un bloc plein ou obtenus par un assemblage de plaques rainurées superposées, par exemple.

Le fluide caloporteur est déplacé dans chaque module thermique 3 selon un mouvement de va-et-vient à travers l'élément magnétocalorique 4, de part et d'autre de ce dernier. A cet effet, ledit module thermique 3 comprend également un circuit fermé 6 pour la circulation du fluide caloporteur. Ce circuit est réalisé par des canaux reliant les deux extrémités opposées 7 et 8 de l'élément magnétocalorique 4 et comprend un moyen de déplacement 5 déplaçant le fluide caloporteur en lui imprimant un mouvement de va-et-vient. Dans les exemples représentés, le moyen de déplacement 5, 50, 60 est un piston. Il peut toutefois être réalisé sous toute autre forme, telle qu'une membrane, par exemple, pouvant imprimer le mouvement de va-et-vient au fluide caloporteur.

Il ressort de l'ensemble des réalisations décrites que le fait de relier fluidiquement les deux extrémités 7 et 8 de l'élément magnétocalorique 4 permet d'utiliser un seul moyen de déplacement 5, 50, 60 pour entraîner le fluide caloporteur à travers l'élément magnétocalorique 4 dans les deux sens. Cela facilite la construction du générateur thermique selon l'invention et limite également son encombrement car, d'une part, un seul moyen de déplacement 5, 50, 60 est nécessaire pour la circulation du fluide caloporteur dans chaque module thermique et, d'autre part, cela implique la mise en place d'un seul organe de commande dudit moyen de déplacement.

Le générateur thermique 1 comporte également un arrangement magnétique 9 mis en mouvement pour soumettre alternativement chaque élément magnétocalorique 4 à une variation de champ magnétique et créer alternativement, dans ledit élément magnétocalorique 4, un cycle d'échauffement et un cycle de refroidissement, générant la création puis le maintien d'un gradient de température entre les deux extrémités opposées 7 et 8 dudit élément magnétocalorique 4 et le déplacement alterné du fluide caloporteur est synchronisé avec la variation du champ magnétique.

Le piston 5 est déplacé dans une chemise 11 par l'intermédiaire d'un profil de came 19 formant un organe de commande, prévu sur le flanc d'un organe de fermeture de champ 30 agencé pour boucler le flux magnétique généré par l'arrangement magnétique 9. Cet organe de fermeture de champ 30 est situé en regard de la chemise 11 dudit piston 5. Pour un encombrement minimum, l'ensemble des pistons 5, les éléments magnétocaloriques 4, l'arrangement magnétique 9 et l'organe de fermeture de champ 30 sont disposés de manière concentrique autour de l'axe central A. La chemise 11 comporte une ouverture 17 pour permettre au profil de came 19 d'être positionné dans une rainure 18 correspondante du piston 5 afin de manoeuvrer ce dernier. A cet effet, le profil de came 19 est de forme sensiblement sinusoïdale avec une amplitude qui détermine la course des pistons 5 et une phase sinusoïdale correspondant globalement à un cycle d'échauffement et un cycle de refroidissement des éléments magnétocaloriques 4. Ainsi, la rotation de l'organe de fermeture de champ 30, et donc du profil de came 19 entraîne le déplacement des pistons 5, selon un mouvement de va-et-vient. Cette rotation est générée par l'intermédiaire de la rotation de l'arrangement magnétique 9 auquel est couplé magnétiquement l'organe de fermeture de champ 30.

A cet effet, l'arrangement magnétique 9 est constitué par un assemblage de parties aimantées 20 et de parties non aimantées 21 et l'organe de fermeture de champ 30 est réalisé sous la forme d'un anneau en un matériau magnétisable, par exemple du fer, comportant des bossages ou protubérances 22 situés face aux parties aimantées 20 pour permettre un accouplement magnétique avec l'arrangement magnétique 9 et ainsi de réaliser un entraînement en rotation de l'organe de fermeture de champ 30 lors de la rotation l'arrangement magnétique 9. Bien que l'organe de fermeture de champ 30 représenté comporte quatre bossages 22, un seul bossage est suffisant pour réaliser l'accouplement magnétique.

L'arrangement magnétique 9 peut être couplé à un actionneur (non représenté) pour être mobile en rotation par rapport aux éléments magnétocaloriques 4. Le déplacement simultané de l'arrangement magnétique 9 et de l'organe de fermeture de champ 30 permet notamment d'éviter la génération de courants de Foucault. Les éléments magnétocaloriques 4 sont disposés autour de l'arrangement magnétique 9 et entre ce dernier et l'organe de fermeture de champ 30. Ainsi, le déplacement de l'arrangement magnétique 9 soumet les éléments magnétocaloriques 4 à une variation de champ magnétique et, simultanément, entraîne le déplacement de l'organe de fermeture de champ 30.

Le générateur thermique 1 représenté aux figures 1 à 4 présente une configuration propice à un encombrement limité ce, notamment grâce à la structure concentrique autour de l'axe central A et formée par l'arrangement magnétique 9, l'organe de fermeture de champ 30 en forme d'anneau, les éléments magnétocaloriques 4 également disposés concentriquement autour de l'axe central A et enfin les pistons 5 intégrés dans des chemises 11 réalisées dans deux pièces circulaires 12 et également concentriques avec les éléments précités. Un tel générateur thermique 1 peut ainsi présenter une largeur de quelques centimètres.

Les deux pièces circulaires 12 sont symétriques par rapport à leur plan d'assemblage et comportent des évidements 15 formant une partie de la chemise 11 des pistons 5 et une rainure 16 reliant fluidiquement chaque évidement 15 à l'élément magnétocalorique 4 correspondant. Les pièces circulaires 12 sont disposées de telle sorte que le profil de came 19 est positionné dans la rainure 18 de chaque piston 5. Les évidements 15 et les rainures 16 des pièces circulaires 12 peuvent être réalisés par forage, perçage, moulage ou tout autre procédé analogue et constituent une partie du circuit fermé 6 pour la circulation du fluide caloporteur.

Le générateur 1 comporte également deux couvercles de protection 23 qui ferment les rainures 16 des pièces circulaires 12 de manière étanche.

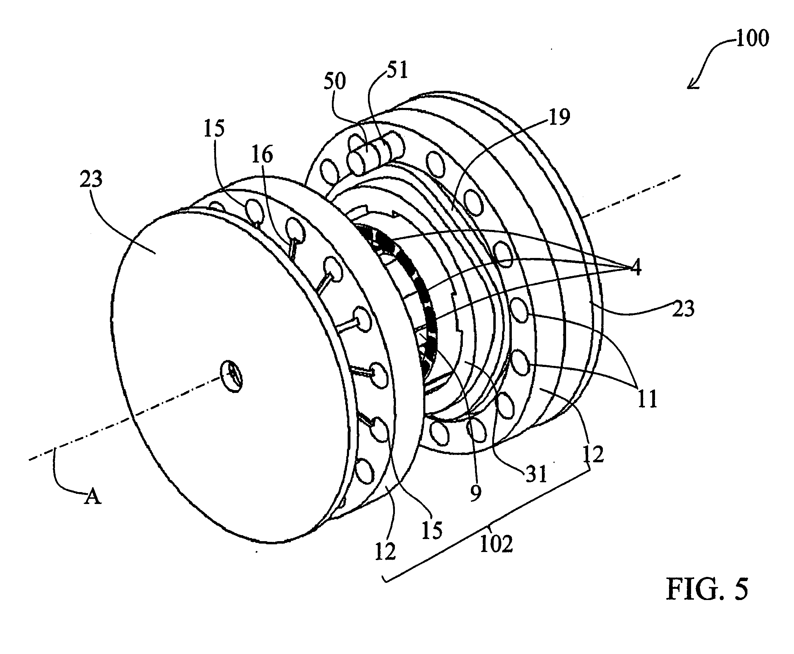

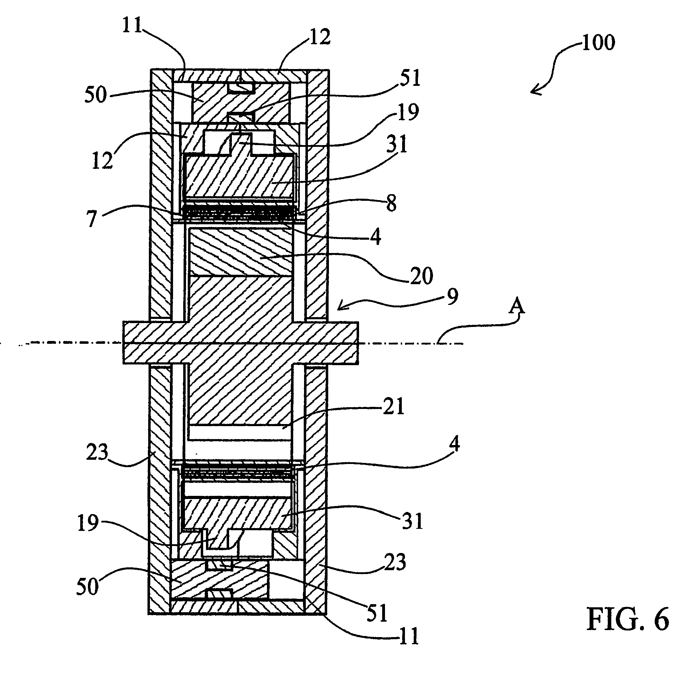

Le générateur thermique 100 représenté aux figures 5 et 6 est réalisé selon une variante du mode de réalisation dans lequel la structure dudit générateur 100 est circulaire et comporte une unité 102 de génération de flux thermique circulaire. La configuration de ce générateur est sensiblement identique à celle du générateur 1 représenté aux figures 1 à 4 et apporte les mêmes avantages, notamment en terme d'encombrement réduit. Toutefois, la manoeuvre du piston 50 est différente. Comme précédemment, l'organe de commande des pistons 50 est constitué par l'organe de fermeture de champ 31. Par contre, les pistons 50 sont munis d'un anneau 51 en un matériau magnétisable qui s'accouple magnétiquement à l'organe de fermeture de champ 31 et suit la rotation de ce dernier sans contact. Ledit organe de fermeture de champ 31 peut également comporter un profil de came 19 tel que celui du générateur thermique 1 des figures 1 à 4. Toutefois, dans cet exemple, il n'est plus nécessaire de prévoir une rainure dans chaque piston 50, l'organe de fermeture de champ 31 entraînant chaque piston 50 sans aucun contact, par accouplement magnétique. Il n'y a donc aucun risque d'usure entre l'organe de commande et les pistons 50. De préférence, les pistons 50 sont sensiblement cylindriques et présentent une zone en matériau magnétisable 51 sous la forme d'un anneau monté dans une rainure circulaire dudit piston 50.

Toute autre forme de piston peut également convenir et peut être déterminée pour minimiser les pertes de charges hydrauliques.

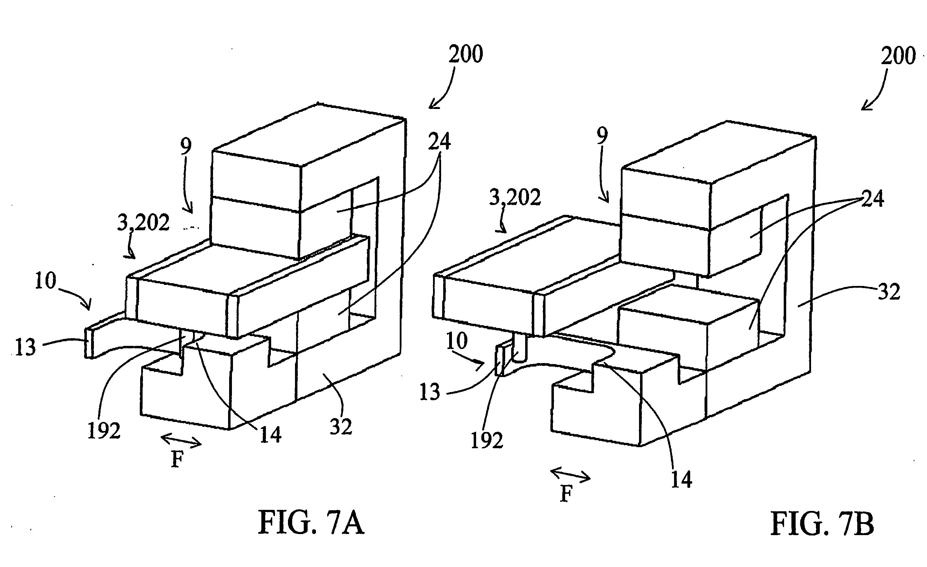

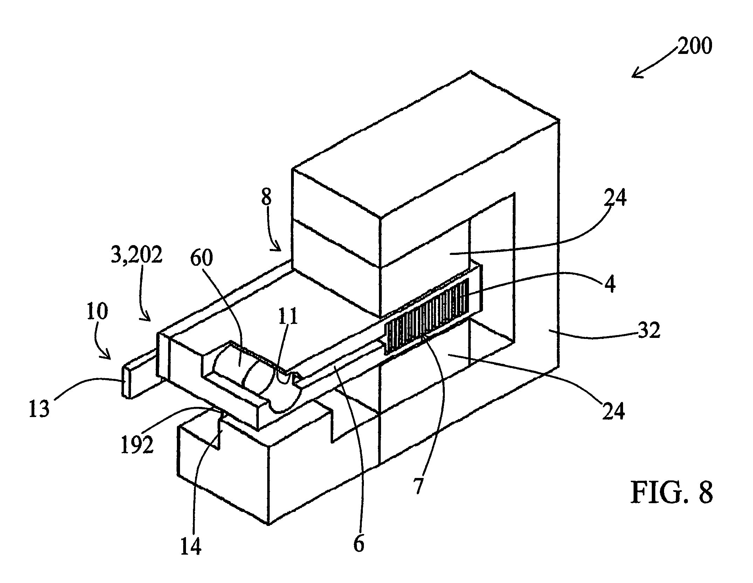

Les figures 7A, 7B et 8 représentent un générateur thermique 200 selon un second mode de réalisation de l'invention, dans lequel la structure dudit générateur 200 est sensiblement linéaire. La figure 8 représente plus particulièrement au niveau de la partie coupée le circuit fermé 6 de circulation de fluide caloporteur, l'élément magnétocalorique 4 et le piston 60.

L'unité de génération de flux thermique 202 est linéaire, les éléments magnétocaloriques 4 étant alignés. Dans l'exemple représenté, le générateur thermique 200 est constitué par une seule unité 202 comportant un module thermique 3. L'invention couvre, bien entendu, des générateurs thermiques comportant plusieurs unités de génération de flux thermiques. Le nombre d'unités et de modules thermiques sera déterminé en fonction de la puissance du générateur thermique.

L'organe de fermeture de champ 32 présente un profil en forme d'étrier dont les deux branches sont munies sur leurs faces internes d'aimants permanents 24 de polarités opposées et formant l'arrangement magnétique 9. Le déplacement en translation selon un mouvement de va-et-vient (selon la flèche F) de l'organe de fermeture de champ 32 et de l'arrangement magnétique 9 expose à une variation du champ magnétique les éléments magnétocaloriques 4 alignés entre les aimants 24. En outre, l'organe de fermeture de champ 32 comporte, pour chaque piston 60, un doigt d'entraînement 192 pour l'entraînement de ce dernier. Ledit doigt d'entraînement assure le couplage mécanique entre l'organe de fermeture de champ 32 et les moyens de déplacement du fluide caloporteur, ici sous la forme de pistons 60. Ainsi, le déplacement de l'arrangement magnétique 32 entraîne, d'une part, une variation du champ magnétique dans les éléments magnétocaloriques 4, et donc une alternance de cycles d'échauffement et de refroidissement de ces derniers, et, d'autre part, le déplacement simultané des doigts d'entraînement 192 qui déplacent à leur tour les pistons 60 dans la chemise 11 correspondante, et donc le fluide caloporteur dans le circuit fermé 6.

En outre, le générateur 200 représenté comprend un moyen de décalage 10 permettant de décaler le déplacement dudit piston 60 par rapport à celui de arrangement magnétique 32. Ce moyen est réalisé sous la forme de deux butées 13, 14 réalisées dans une pièce en forme de U montée sur l'organe de fermeture de champ 32. Ces deux butées 13, 14 sont disposées sous le piston 60 et coopèrent avec le doigt d'entraînement 192. Ce dernier est donc entraîné par ces deux butées 13, 14 lorsque l'organe de fermeture de champ 32 se déplace selon la flèche F. Elles permettent de contrôler le déplacement du piston 60 en synchronisme avec le déplacement de l'organe de fermeture de champ 32.

Ainsi, sur la figure 7A, lorsque l'organe de fermeture de champ 32 se déplace vers la droite, il n'entraîne le doigt d'entraînement 192, et donc le piston 60 associé à ce dernier que lorsque la butée 14 arrive au contact dudit doigt d'entraînement 192, position représentée à la figure 7B. Au cours de ce déplacement, l'élément magnétocalorique 4 est sorti du champ magnétique des aimants 24 et a subi un cycle de refroidissement sans que le piston 60 n'ait été déplacé. L'échange thermique entre le fluide caloporteur et l'élément magnétocalorique 4 se fait donc lorsque la butée 14 arrive au contact du doigt d'entraînement 192 et que l'organe de fermeture de champ 32 se déplace encore vers la droite sur la figure, déplaçant ainsi le piston 60 dans le circuit fermé 6. La course complète de l'organe de fermeture de champ 32 n'est pas transmise totalement au piston 60.

Inversement, lors du déplacement de l'organe de fermeture de champ 32 vers la gauche sur la figure 7b, l'élément magnétocalorique 4 est soumis à un champ magnétique et subit un cycle d'échauffement sans qu'il n'y ait de déplacement de piston 60 et donc de fluide caloporteur. Lorsque le doigt d'entraînement 192 arrive en contact avec la butée 13, cette dernière l'entraîne, ce qui induit un déplacement du piston 60 correspondant et donc un déplacement du fluide caloporteur dans le circuit fermé 6 et donc un échange thermique entre ce dernier et l'élément magnétocalorique 4.

Un tel moyen de décalage permet d'optimiser l'échange thermique entre le fluide caloporteur et l'élément magnétocalorique 4 en réalisant ce dernier après un changement de phase dudit élément magnétocalorique 4, et donc d'augmenter le rendement du générateur 200.

Dans une variante non représentée, l'organe de fermeture de champ peut présenter un profil en forme d'étrier dont les deux branches sont munies sur leurs faces internes d'aimants permanents de polarités opposées et formant l'arrangement magnétique, ledit organe de commande peut toutefois comporter deux aimants permanents de polarités différentes disposés à distance et en regard l'un de l'autre et le piston peut comporter un aimant disposé par rapport aux aimants permanents de l'organe de commande de manière à être repoussé par chacun de ces derniers, et donc suivre leur déplacement. Le déplacement de l'organe de commande entraîne ainsi celui du piston, sans contact entre ces derniers, en dehors de l'arrangement magnétique. A cet effet, le piston peut être disposé sensiblement entre les deux aimants permanents de l'organe de commande et préférentiellement au-dessus de ces derniers.

Bien que l'ensemble des dessins annexés illustrent des générateurs thermiques 1, 100, 200 comportant une seule unité de génération de flux thermique 2, l'invention prévoit également la réalisation d'un générateur thermique présentant une structure étagée avec plusieurs unités de génération de flux thermique 2, 102, 202. Une telle configuration permet d'augmenter le rendement du générateur thermique selon l'invention.

### Possibilités d'application industrielle :

Il ressort clairement de cette description que l'invention permet d'atteindre les buts fixés, à savoir proposer un générateur thermique 1, 100, 200 de construction simple et peu encombrante limitant le nombre d'organes en déplacement pour la circulation du fluide caloporteur dans les modules thermiques 3.

Un tel générateur thermique 1, 100, 200 peut trouver une application aussi bien industrielle que domestique dans le domaine du chauffage, de la climatisation, du tempérage, refroidissement ou autres, ce, à des coûts compétitifs et dans un faible encombrement.

En outre, toutes les pièces composant ce générateur thermique 1, 100, 200 peuvent être réalisées selon des processus industriels reproductibles.

La présente invention n'est pas limitée à l'exemple de réalisation décrit mais s'étend à toute modification et variante évidentes pour un homme du métier tout en restant dans l'étendue de la protection définie dans les revendications annexées.

## Revendications

1. Générateur thermique à matériau magnétocalorique comportant au moins une unité (2, 102, 202) de génération de flux thermique pourvue d'au moins un module thermique (3) contenant un élément magnétocalorique (4), traversé par un fluide caloporteur entraîné selon un déplacement alterné de part et d'autre dudit élément magnétocalorique (4), ledit générateur thermique (1) comportant également un arrangement magnétique (9, 24) mis en mouvement pour soumettre alternativement ledit élément magnétocalorique (4) à une variation de champ magnétique et créer alternativement, dans ledit élément magnétocalorique (4), un cycle d'échauffement et un cycle de refroidissement, générant la création puis le maintien d'un gradient de température entre les deux extrémités opposées (7 et 8) dudit élément magnétocalorique (4), le déplacement alterné du fluide caloporteur étant synchronisé avec la variation du champ magnétique, ladite unité (2, 102, 202) de génération de flux thermique comportant un organe de fermeture de champ (30, 31, 32) agencé pour boucler le flux magnétique généré par l'arrangement magnétique (9, 24), générateur, élément magnétocalorique (4) étant intégré dans un circuit fermé (6) de circulation de fluide caloporteur reliant les deux extrémités opposées (7 et 8) dudit élément magnétocalorique (4), en ce que ledit circuit fermé (6) intégrant un unique moyen de déplacement (5, 50, 60) du fluide caloporteur à travers ledit élément magnétocalorique (4) dans les deux sens de déplacement, et ledit organe de fermeture de champ (30, 31, 32) étant muni d'un organe de commande (19, 192) dudit moyen de déplacement (5, 50, 60).

2. Générateur thermique, selon la revendication 1, **caractérisé en ce que** ledit circuit fermé (6) est réalisé par un ou plusieurs conduits ou canaux reliant les extrémités opposées (7, 8) dudit élément magnétocalorique (4).

3. Générateur thermique, selon la revendication 1, **caractérisé en ce que** ledit moyen de déplacement est un piston (5, 50, 60) qui se déplace dans une chemise (11) formée dans le circuit fermé (6) correspondant.

4. Générateur thermique, selon la revendication 3, **caractérisé en ce que** l'organe de fermeture de champ (30, 31) est réalisé en un matériau magnétisable et couplé magnétiquement audit arrangement magnétique (9) mobile.

5. Générateur thermique, selon la revendication 4, **caractérisé en ce que** l'organe de commande est un profil de came (19) de forme sensiblement sinusoïdale dont l'amplitude détermine la course des pistons (5) et dont la phase sinusoïdale correspond globalement à un cycle d'échauffement et un cycle de refroidissement des éléments magnétocaloriques (4).

6. Générateur thermique, selon la revendication 5, **caractérisé en ce que** ledit piston (5) comporte une rainure (18) dans laquelle circule ledit profil de came (19).

7. Générateur thermique, selon la revendication 4, **caractérisé en ce que** ledit piston (50) comporte une zone en matériau magnétisable (51) et est couplé magnétiquement audit organe de fermeture de champ (31) formant l'organe de commande.

8. Générateur thermique, selon l'une quelconque des revendications précédentes, dans lequel ladite unité (2, 102) de génération de flux thermique est pourvue de plusieurs modules thermiques (3) et présente une structure circulaire dans laquelle les éléments magnétocaloriques (4) sont disposés en cercle autour d'un axe central (A), l'arrangement magnétique (9) est entraîné en rotation autour dudit axe central (A), et lesdits éléments magnétocaloriques (4) sont disposés entre l'arrangement magnétique (9) et l'organe de fermeture de champ (30, 31), **caractérisé en ce que** l'organe de fermeture de champ (30, 31) est couplé magnétiquement audit arrangement magnétique (9), **en ce que** ledit circuit fermé (6) et la chemise (11) dudit piston sont réalisés dans deux pièces circulaires (12) destinées à être assemblées, et **en ce que** lesdites pièces circulaires sont sensiblement symétriques par rapport à leur plan d'assemblage, et comportent chacune au moins un évidement (15) formant une partie de la chemise d'un piston (5) et une rainure (16) aux extrémités débouchantes et formant un canal de liaison entre ledit évidement (15) et l'élément magnétocalorique (4) correspondant.

9. Générateur thermique, selon l'une quelconque des revendications 1 à 4, dans lequel ladite unité (202) de génération de flux thermique présente une structure linéaire dans laquelle les éléments magnétocaloriques (4) sont alignés et en ce que l'arrangement magnétique (9) est entraîné en translation alternative le long desdits éléments magnétocaloriques (4), **caractérisé en ce que** l'organe de fermeture de champ (32) présente un profil en forme d'étrier dont les deux branches sont munies sur leurs faces internes d'aimants permanents (24) de polarités opposées et formant l'arrangement magnétique (9) et **en ce que** ledit organe de commande (192) est sous la forme d'un doigt d'entraînement logé dans une gorge (25) correspondante de chaque piston (60).

10. Générateur thermique, selon l'une quelconque des revendications 1 à 4, dans lequel ladite unité de génération de flux thermique présente une structure linéaire dans laquelle les éléments magnétocaloriques sont alignés et l'arrangement magnétique est entraîné en translation alternative le long desdits éléments magnétocaloriques, **caractérisé en ce que** l'organe de fermeture de champ présente un profil en forme d'étrier dont les deux branches sont munies sur leurs faces internes d'aimants permanents de polarités opposées et formant l'arrangement magnétique, **en ce que** ledit organe de commande comporte deux aimants permanents de polarités différentes disposés à distance et en regard l'un de l'autre et **en ce que** le piston comporte un aimant disposé par rapport aux aimants permanents de l'organe de commande de manière à être repoussé par chacun de ces derniers.

11. Générateur thermique, selon l'une quelconque des revendications 9 et 10, **caractérisé en ce qu'**il comprend un moyen de décalage (10) apte à anticiper et/ou à retarder le déplacement dudit piston (60) par rapport à celui de l'arrangement magnétique (9).

## Claims

1. Heat generator with magnetocaloric material comprising at least one thermal flux generation unit (2, 102, 202) provided with at least one thermal module (3) containing a magnetocaloric element (4), crossed by a heat transfer fluid circulated according to an alternating movement on both sides of said magnetocaloric element (4), said heat generator (1) comprising also a magnetic arrangement (9, 24) put in motion to subject alternately said magnetocaloric element (4) to a magnetic field variation and create alternately in said magnetocaloric element (4), a heating cycle and a cooling cycle, generating the creation of, and then maintaining, a temperature gradient between the two opposite ends (7 and 8) of said magnetocaloric element (4), the alternating displacement of the heat transfer fluid being synchronised with the magnetic field variation, said thermal flux generation unit (2, 102, 202) comprising a field closing device (30, 31, 32) arranged to loop the magnetic flux generated by the magnetic arrangement (9, 24), said magnetocaloric element (4) being integrated in a closed heat transfer fluid circulation circuit (6) connecting the two opposite ends (7 and 8) of said magnetocaloric element (4), said closed circuit (6) comprising a single means of displacement (5, 50, 60) of the heat transfer fluid through said magnetocaloric element (4) in both displacement directions, and said field closing device (30, 31, 32) being provided with a control device (19, 192) of said means of displacement (5, 50, 60).

2. Heat generator according to claim 1, **characterized in that** said closed circuit (6) is made of one or several conduits or channels connecting the opposite ends (7, 8) of said magnetocaloric element (4).

3. Heat generator according to claim 1, **characterized in that** said means of displacement is a piston (5, 50, 60) that moves in a jacket (11) formed in the corresponding closed circuit (6).

4. Heat generator according to claim 3, **characterized in that** the field closing device (30, 31) is made out of a magnetizable material and is coupled magnetically with said mobile magnetic arrangement (9).

5. Heat generator according to claim 4, **characterized in that** the control device is a cam profile (19) with an approximately sinusoidal shape whose amplitude determines the stroke of the pistons (5) and whose sinusoidal phase corresponds globally to a heating cycle and a cooling cycle of the magnetocaloric elements (4).

6. Heat generator according to claim 5, **characterized in that** said piston (5) comprises a groove (18) in which said cam profile (19) circulates.

7. Heat generator according to claim 4, **characterized in that** said piston (50) comprises an area out of a magnetisable material (51) and is coupled magnetically with said field closing device (31) forming the control device.

8. Heat generator according to any of the previous claims, in which said thermal flux generation unit (2, 102) is provided with several thermal modules (3) and has a circular structure in which the magnetocaloric elements (4) are arranged on a circle around a central axis (A), the magnetic arrangement (9) is rotated around said central axis (A) and said magnetocaloric elements (4) are arranged between the magnetic arrangement (9) and the field closing device (30, 31), **characterized in that** the field closing device (30, 31) is coupled magnetically with said magnetic arrangement (9), **in that** said closed circuit (6) and the jacket (11) of said piston are made in two circular parts (12) meant for being assembled, and **in that** said circular parts are approximately symmetrical with respect to their assembly plane, and comprise each at least one recess (15) forming a part of the jacket of a piston (5) and a groove (16) with open ends and forming a connection channel between said recess (15) and the corresponding magnetocaloric element (4).

9. Heat generator according to any of the claims 1 to 4, in which said thermal flux generation unit (202) has a linear structure in which the magnetocaloric elements (4) are aligned and the magnetic arrangement (9) is driven in reciprocating translation along said magnetocaloric elements (4), **characterized in that** the field closing device (32) has a yoke-shaped profile whose both legs are provided, on their internal faces, with permanent magnets (24) with opposite polarities and making up the magnetic arrangement (9) and **in that** said control device (192) has the shape of a driving pin housed in a corresponding groove (25) of each piston (60).

10. Heat generator according to any of the claims 1 to 4, in which said thermal flux generation unit has a linear structure in which the magnetocaloric elements are aligned and the magnetic arrangement is driven in reciprocating translation along said magnetocaloric elements, **characterized in that** the field closing device has a yoke-shaped profile whose both legs are provided, on their internal faces, with permanent magnets with opposite polarities and making up the magnetic arrangement, **in that** said control device comprises two permanent magnets with different polarities located at a distance and opposite to each other and **in that** the piston comprises a magnet arranged with respect to the permanent magnets of the control device so as to be pushed back by each of the latter.

11. Heat generator according to any of the claims 9 and 10, **characterized in that** it comprises an offset means (10) suitable for anticipating and/or delaying the movement of said piston (60) with respect to that of the magnetic arrangement (9).

## Patentansprüche

1. Wärmegenerator mit magnetokalorischem Material bestehend aus mindestens einer Einheit (2, 102, 202) zur Erzeugung eines Wärmeflusses, ausgestattet mit mindestens einem Wärme-Modul (3), das ein magnetokalorisches Element (4) beträgt, welches von einem in einer Hin-und-Her-Bewegung zu beiden Seiten des besagten magnetokalorischen Elements (4) getriebenen Wärmeübertragungsfluid durchströmt wird, wobei der besagte Wärmegenerator (1) ebenfalls eine magnetische Anordnung (9, 24) beträgt, die in Bewegung gesetzt wird, um abwechselnd das besagte magnetokalorische Element (4) einer Magnetfeld-Variation auszusetzen und abwechselnd in dem besagten magnetokalorischen Element (4) einen Heiz-Zyklus und einen Kühl-Zyklus zu erzeugen, wodurch ein Temperatur-Gradient zwischen den beiden entgegen gesetzten Enden (7 und 8) des besagten magnetokalorischen Elements (4) erzeugt und anschließend erhalten wird, wobei die abwechselnde Bewegung des Wärmeübertragungsfluids mit der Magnetfeld-Variation synchronisiert ist, wobei die besagte Einheit (2, 102, 202) zur Erzeugung eines Wärmeflusses ein Element (30, 31, 32) zum Schließen des Magnetfelds beträgt, das angeordnet ist, um den von der magnetischen Anordnung (9, 24) erzeugten Magnetfluss zu schließen, wobei das besagte magnetokalorische Element (4) in einen geschlossenen Kreislauf (6) für die Zirkulation des Wärmeübertragungsfluids integriert ist, der die beiden entgegen gesetzten Enden (7 und 8) des besagten magnetokalorischen Elements (4) verbindet, wobei der besagte geschlossene Kreislauf (6) ein einziges Mittel (5, 50, 60) zur Zirkulation des Wärmeübertragungsfluids in beide Richtungen durch das besagte magnetokalorische Element (4) hindurch beträgt, und wobei das besagte Element (30, 31, 32) zum Schließen des Magnetfelds mit einem Antriebs-Element (19, 192) für das besagte Zirkulationsmittel (5, 50, 60) versehen ist.

2. Wärmegenerator nach Anspruch 1, **dadurch gekennzeichnet, dass** der besagte geschlossene Kreislauf (6) aus einer oder mehreren Leitungen oder Kanälen besteht, die die entgegen gesetzten Enden (7, 8) des besagten magnetokalorischen Elements (4) verbinden.

3. Wärmegenerator nach Anspruch 1. **dadurch gekennzeichnet, dass** das besagte Zirkulationsmittel aus einem Kolben (5, 50, 60) besteht, der sich in einem in dem entsprechenden geschlossenen Kreislauf (6) gebildeten Mantel (11) bewegt.

4. Wärmegenerator nach Anspruch 3, **dadurch gekennzeichnet, dass** das Element (30, 31) zum Schließen des Magnetfelds aus einem magnetisierbaren Material besteht und magnetisch mit der besagten beweglichen magnetischen Anordnung (9) gekoppelt ist.

5. Wärmegenerator nach Anspruch 4, **dadurch gekennzeichnet, dass** das Antriebs-Element ein merklich sinusförmiges Steuerkurvenprofil (19) ist, deren Ausschlag den Hub der Kolben (5) bestimmt und deren Sinusphase global einem Heiz-Zyklus und einem Kühl-Zyklus der magnetokalorischen Elemente (4) entspricht.

6. Wärmegenerator nach Anspruch 5, **dadurch gekennzeichnet, dass** der besagte Kolben (5) eine Nut (18) beträgt, in der das besagte Steuerkurvenprofil (19) läuft.

7. Wärmegenerator nach Anspruch 4, **dadurch gekennzeichnet, dass** der besagte Kolben (50) einen Bereich aus magnetisierbarem Material (51) beträgt und magnetisch mit dem besagten Element (31) zum Schließen des Magnetfelds gekoppelt ist, das das Antriebs-Element bildet.

8. Wärmegenerator nach einem beliebigen der vorhergehenden Ansprüche, in dem die besagte Einheit (2, 102) zur Erzeugung eines Wärmeflusses mit mehreren Wärme-Modulen (3) ausgestattet ist und eine kreisförmige Struktur aufweist, in der die magnetokalorischen Elemente (4) auf einem Kreis um eine Mittelachse (A) angeordnet sind, die magnetische Anordnung (9) um die besagte Mittelachse (A) in Drehung angetrieben wird, und die besagten magnetokalorischen Elemente (4) zwischen der magnetischen Anordnung (9) und dem Element (30, 31) zum Schließen des Magnetfelds angeordnet sind, **dadurch gekennzeichnet, dass** das Element (30, 31) zum Schließen des Magnetfelds magnetisch mit der besagten magnetischen Anordnung (9) gekoppelt ist, dadurch, dass der besagte geschlossene Kreislauf (6) und der Mantel (11) des besagten Kolbens aus zwei kreisförmigen Teilen (12) hergestellt sind, die dazu bestimmt sind, zusammengebaut zu werden, und dadurch, dass die besagten kreisförmigen Teile in Bezug auf ihre Montageflächen merklich symmetrisch sind und jeweils mindestens einen Hohlraum (15) betragen, der einen Teil des Mantels eines Kolbens (5) bildet, sowie eine Nut (16) mit offenen Enden, die einen Verbindungskanal zwischen dem besagten Hohlraum (15) und dem entsprechenden magnetokalorischen Element (4) bildet.

9. Wärmegenerator nach einem beliebigen der Ansprüche 1 bis 4, in dem die besagte Einheit (202) zur Erzeugung eines Wärmeflusses eine lineare Struktur aufweist, in der die magnetokalorischen Elemente (4) auf einer Reihe angeordnet sind und die magnetische Anordnung (9) entlang der besagten magnetokalorischen Elemente (4) in einer abwechselnden hin und her Translation angetrieben wird, **dadurch gekennzeichnet, dass** das Element (32) zum Schließen des Magnetfelds ein bügelförmiges Profil aufweist, dessen beide Schenkel auf ihren Innenseiten mit Permanentmagneten (24) mit entgegen gesetzten Polaritäten ausgestattet sind, die die magnetische Anordnung (9) bilden, und dadurch, dass das besagte Antriebs-Element (192) die Form eines in einer entsprechenden Nut (25) jedes Kolbens (60) untergebrachten Antriebs-Fingers hat.

10. Wärmegenerator nach einem beliebigen der Ansprüche 1 bis 4, in dem die besagte Einheit zur Erzeugung eines Wärmeflusses eine lineare Struktur aufweist, in der die magnetokalorischen Elemente auf einer Reihe angeordnet sind und die magnetische Anordnung entlang der besagten magnetokalorischen Elemente in einer abwechselnden hin und her Translation angetrieben wird, **dadurch gekennzeichnet, dass** das Element zum Schließen des Magnetfelds ein bügelförmiges Profil aufweist, dessen beide Schenkel auf ihren Innenseiten mit Permanentmagneten mit entgegen gesetzten Polaritäten ausgestattet sind, die die magnetische Anordnung bilden, dadurch, dass das besagte Antriebs-Element zwei entfernt voneinander und gegenüberliegend angeordnete Permanentmagnete mit unterschiedlichen Polaritäten beträgt, und dadurch, dass der Kolben ein Magnet beträgt, der in Bezug auf die Permanentmagnete des AntriebsElements angeordnet ist, um von jedem dieser abgestoßen zu werden.

11. Wärmegenerator nach einem beliebigen der Ansprüche 9 und 10, **dadurch gekennzeichnet, dass** er ein Verschiebungsmittel (10) beträgt, das in der Lage ist, die Bewegung des besagten Kolbens (60) in Bezug auf die Bewegung der magnetischen Anordnung (9) vorwegzunehmen und/oder zu verzögern.
